Europäisches Patentamt

European Patent Office

Office européen des brevets

(11) Publication number: **0 148 396**
**B1**

(12) **EUROPEAN PATENT SPECIFICATION**

(45) Date of publication of patent specification: 07.02.90

(51) Int. Cl.⁵: **C 30 B 15/14**

(21) Application number: **84114480.1**

(22) Date of filing: **29.11.84**

(54) **Apparatus for producing gallium arsenide single crystal and gallium arsenide single crystal produced by said apparatus.**

(30) Priority: **30.11.83 JP 227305/83**

(43) Date of publication of application:
**17.07.85 Bulletin 85/29**

(45) Publication of the grant of the patent:
**07.02.90 Bulletin 90/06**

(84) Designated Contracting States:
**DE FR GB**

(56) References cited:
**EP-A-0 140 509**

**PATENT ABSTRACTS OF JAPAN, vol. 7, no. 205
(C-185)1350r, 9th September 1983; & JP-A-58
104 092 (TOUHOKU KINZOKU KOGYO K.K.)
21-06-1983**

**PATENT ABSTRACTS OF JAPAN, vol. 7, no. 247
(E-208)1392r, 2nd November 1983; & JP-A-58
135 626 (NIPPON DENSHIN DENWA KOSHA)
12-08-1983**

(73) Proprietor: **SUMITOMO ELECTRIC INDUSTRIES
LIMITED
No. 15, Kitahama 5-chome Higashi-ku
Osaka-shi Osaka 541 (JP)**

(72) Inventor: **Kishi, Masao c/o Osaka Works of
Sumitomo
Electric Industries, Ltd. 1-3, Shimaya 1-chome
Konohana-ku Osaka-shi Osaka (JP)**
Inventor: **Banba, Yoshiyuki c/o Osaka Works of
Sumitomo
Electric Industries, Ltd. 1-3, Shimaya 1-chome
Konohana-ku Osaka-shi Osaka (JP)**

(74) Representative: **Patentanwälte Grünecker,
Kinkeldey, Stockmair & Partner
Maximilianstrasse 58
D-8000 München 22 (DE)**

## Description

Background of the Invention

1. Field of the Invention

The present invention relates to an apparatus for producing a large-diameter single crystal of gallium arsenide that is doped with boron, antimony or indium as an impurity and which is substantially free of lattice defects. The present invention also relates to a large-diameter single crystal of gallium arsenide produced by such apparatus.

2. Prior Art

Single-crystal gallium arsenide (hereunder abbreviated as GaAs) are used as the substrate for electronic devices such as field-effect transistors, light-emitting diodes and laser diodes.

GaAs crystals are typically grown by the horizontal Bridgman method or the Czochralski method. In the horizontal Bridgman method (HB method), a molten semiconductor is solidified in a quartz boat by the relative and horizontal movement of a temperature gradient. An advantage of the HB method is that it is capable of producing a relatively defect-free single crystal by reducing the temperature gradient. However, this method provides only an ingot of a semi-circular cross section since the growth of a single crystal occurs within the boat. When a circular wafer is sliced from the ingot by oblique cutting, a significant proportion of the crystal is wasted. Because of this materials loss, the HB method is not highly cost-effective.

In the Liquid Encapsulated Czochralski method (LEC method), a melt of the semiconductor is contained in a crucible and a seed crystal is dipped in the free surface of the melt. The seed is slowly pulled up out of the melt. Since the crystal growth takes place in the vertical direction, the CZ method has the advantage that a single-crystal ingot with a circular cross section can be obtained fairly easily. As a further advantage, the CZ method is sufficiently protected from the entrance of impurities to ensure the growth of a highly insulating single crystal with a high specific resistivity.

The fabrication of field-effect transistors (FETs) requires a substrate of high specific resistivity. The substrate prepared by the HB method has a relatively low specific resistance since silicon atoms in the quartz boat enter the growing crystal and act as electron donors. This defect is free from the single crystals of GaAs grown by the CZ method. However, lattice defects easily occur in the single crystal grown by the CZ method since it creates a large temperature gradient at the solid-liquid interface.

The amount of lattice defects can be estimated by counting the density of dislocations, which is equivalent to the number of etch pits in a unit area, or the etch pit density (EPD). The measurement of EPD requires the preparation of a thin wafer sliced from a grown, single-crystal ingot, polishing the wafer to a mirror surface and etching the polished surface. Areas with dislocations emerge on the etched surface as small pits. The number of the small pits is counted under a microscope and is divided by the area of the wafer to obtain the etch pit density (EPD).

A. Distribution of EPD

The etch pit density (EPD) of an ingot varies in a complex manner which can be summarized as follows:

(1) The top of the ingot which is closer to the seed crystal generally has a smaller EPD than the bottom of the ingot. Having many defects and hence a high EPD, the bottom of the ingot often becomes polycrystalline rather than single-crystal.

(2) The EPD also varies greatly in the radial direction of a wafer sliced from the ingot. The peripheral portion of the wafer has many defects and hence a high EPD. The center of the wafer also has a high EPD. The area between the center and the periphery of the wafer has a low EPD. Therefore, the EPD distribution over the cross section of a wafer is generally W-shaped.

(3) For the same reason as shown in (2), the amount of increase in EPD around the circumference of the ingot becomes appreciable as the ingot diameter increases. An ingot of a large diameter has a great variation in thermal stress in the radial direction, which leads to a significant increase in the lattice defects in the peripheral portion.

A single crystal of a small diameter can be easily grown by the CZ method. For example, single crystals with diameters of 10—20 mm having EPDs in the range of $1—5 \times 10^4/cm^2$ can be produced with relative ease. However, 2-inch (ca. 50 mm) or 3-inch (ca. 75 mm) single crystals of low EPD are difficult to prepare.

Most of the single crystals grown by the CZ method have EPDs in the range of $5—15 \times 10^4/cm^2$. Even if utmost care is taken to reduce the temperature gradient at the solid-liquid interface, the EPD cannot be reduced below the range of $1—5 \times 10^4/cm^2$.

If wafers having such high defect densities are used as the substrate, FETs having significant variations in the pinch-off voltage result. The pinch-off voltage is an important design parameter and must be the same for all unit devices in order to assemble them into an integrated circuit. In other words, the fabrication of an integrated GaAs FET circuit is impossible without a wafer of low EPD.

The situation is more difficult in the fabrication of light-emitting diodes and laser diodes. Since these devices receive a fairly large current in a small area, a lattice defect will serve as the center for the rapid deterrioration of the performance of the devices. As with FETs, these devices have a strong need for lower EPDs.

B. Liquid encapsulated Czokralski method (LEC method)

In commercial operations, GaAs single crystals are grown by a modified Czochralski method. Having a high vapor pressure, arsenic atoms easily slip out of the melt of the compound. Even if polycrystalline GaAs is melted, its high temperature (the melting point of GaAs is 1238°C) causes the escape of arsenic in a gaseous form. The resulting deviation from stoichiometry simply produces an ingot having many As vacancies in lattices.

In order to prohibit the escape of As atoms, the top of the melt in a crucible is covered with a melt of $B_2O_3$. At the melting point of GaAs, $B_2O_3$ becomes liquid, and because of its lower specific gravity than that of the molten GaAs, the latter can be completely covered with $B_2O_3$. In many cases, the covering with $B_2O_3$ is combined with filling the heating furnace with an inert gas at a pressure at least $10^6$Pa. By this design, $B_2O_3$ provides a nearly perfect seal against the escape of As atoms from the molten GaAs. This technique, generally referred to as the liquid encapsulated Czochralski (LEC) method, is used almost exclusively in pulling a GaAs crystal. Today, the single crystals of GaAs are seldom grown with the surface of the GaAs melt left uncovered.

C. The theory and method of Willardson

R. K. Willardson, W. P. Allred and J. E. Cook first proposed the effectiveness of impurity doping in growing the single crystals of III-V semiconductor compounds having enhanced electron mobility.

U.S. Patent No. 3,496,118 (issued February 17, 1970) sets forth Willardson's method of crystal pulling and the theory which underlies it. The applicability of his method is not limited to the growing of the GaAs crystals; it is also applicable to the growing of the single crystals of many other compounds such as GaP, GaSb, InAs, InP, InSb, AlP, AlAs and AlSb.

The present inventors do not think that Willardson's idea is completely correct although it was well beyond the state of the art that existed on April 19, 1966, the filing date of the application on which U.S. Patent No. 3,496,118 was granted.

In the following pages, the theory behind the Willardson patent is explained for better understanding of the present invention. High quality single-crystal semiconductors require enhanced electron mobility. The primary reason for low electron mobility is the lattice defects in a single crystal. Typical lattice defects are dislocations, but impurities present in the crystal also provide the center for electron scattering and reduce the electron mobility. It is therefore necessary to eliminate, among other things, dislocations and other deviations from crystalline perfection.

According to Willardson et al., single crystals of III-V compounds having a melting point not higher than 900°C, such as GaSb and InSb, can be pulled easily. Willardson et al. therefore expected that single crystals of compounds having melting points above 900°C could be pulled without much departure from crystal perfection by lowering the freezing points of these compounds. It is a well known fact that a solute added to a solution lowers its melting point (or freezing point) and increases its boiling point. Willardson et al. reached the idea of adding a certain impurity to the melt in order to decrease its freezing point. The decrease in the freezing point is substantially proportional to the quantity of the impurities added. According to Willardson et al., for the purpose of growing a stoichiometric single crystal of a III-V compound having a melting point above 900°C, the freezing of the molten compound is desirably lowered by at least 100°C. To do so, the impurity must be dissolved in a large quantity in the melt.

However, an impurity present in a large quantity in a single crystal provides the center for electron scattering and decreases the mobility of electrons in the crystal. This introduction of new lattice defects by the presence of impurities must be avoided. Willardson thought that good results would be obtained by using impurities which are contained in the melt in high concentrations but which do not enter the solid and are excluded from the single crystal. As a criterion for selecting the desired impurities, Willardson introduced the concept of "distribution coefficient". Suppose a substance in thermal equilibrium which has both liquid and solid phases. Add an impurity to this substance. The distribution of the added impurity is defined by the ratio of the amount dissolved in one unit volume of the liquid to the amount incorporated into one unit volume of the solid. The distribution coefficient is a phenomenalistic factor that can only be defined in the equilibrium state. An impurity having a distribution coefficient, k, greater than 1 is not easily dissolved in the liquid and is easily incorporated in the solid. An impurity with a distribution coefficient smaller than 1 is not easily incorporated in the solid and is easily dissolved in the liquid.

Based on the understanding shown above, Willardson et al. selected impurities that had small distribution coefficients with respect to III-V compounds. The present inventors evaluate this idea as a good approach. An impurity having a small distribution coefficient (k) can be added in a large quantity to the melt of a III-V compound, thereby lowering its freezing point (or melting point) by, for example, at least 100°C. On the other hand, this impurity will be little incorporated in the solid portion of the crystal being withdrawn upward, and the concentration of the impurity in the crystal will remain low. This would greatly alleviate the problem of lattice defects due to impurities.

Willardson pointed out that even if the distribution coefficient were to remain the same, the impurity concentration would not be held constant if the single crystal is pulled by the Czochralski method. As the single crystal is being pulled, the melt in the crucible is gradually exhausted. An impurity having a distribution coefficient, k, of less than 1 will not be incorporated in the crystal and will remain in the melt. This causes a gradual increase in the concentration of that impurity in the melt, hence in the single crystal being pulled upward. Therefore, the crystal ingot following the seed has a low impurity concentration in the top and a high impurity concentration in the bottom that is formed in the final stage of the crystal growth.

Willardson postulated that the concentration C of an impurity with a distribution coefficient k in a single crystal would be given by:

$$C = kC_0(1 - g)^{k-1} \qquad (1)$$

wherein $C_0$ is an initial impurity concentration in the compound melt, and g is a ratio of solidified part to the initial compound melt by weight and is of course smaller than unity. Before starting to pull the crystal, $g = 0$, and the value of g increases as the crystal grows.

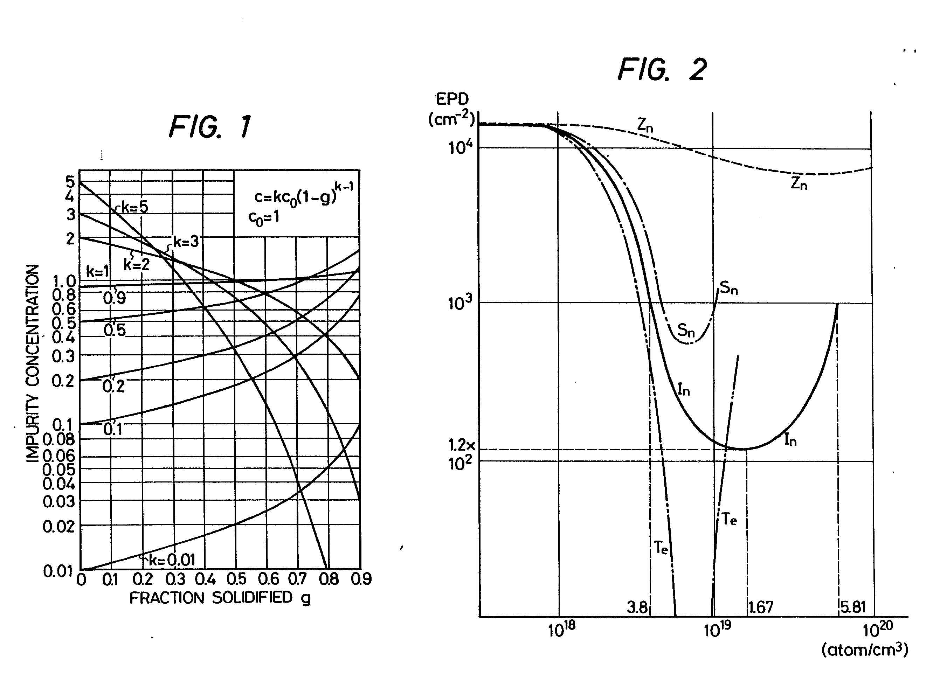

Fig. 1 reproduces the graph incorporated in Willardson's patent for showing the change in solute, or impurity, concentration with solidified fraction with parameter k varying from 0.01 to 5. In Fig. 1, $C_0$ is 1 for all curves.

Willardson does not show how he derived formula (1), but his reasoning may be as follows. Suppose the melt in a crucible has an initial weight $L_0$. If the solidified fraction is g, the weight of the crystal that has solidified is $L_0 g$. The weight of the melt is $L_0 (1 - g)$. Suppose the melt contains an impurity whose weight is m. In the process of single crystal growth, the melt solidifies by a small amount d $(L_0 g)$ and this causes a decrease of the impurity content in the melt by dm.

Distribution coefficient k is expressed as the ratio of the impurity concentration in the melt:

$$\frac{m}{L_0 (1 - g)} \qquad (2)$$

to the impurity concentration in the solid. Since there is no movement of substances in the solid phase, only the freshly solidified portion is in equilibrium with the liquid. The weight of the freshly solidified portion is d $(L_0 g)$ and that of the impurity incorporated in this portion is $-dm$. Therefore, the concentration of the impurity in the solid phase is:

$$\frac{(-dm)}{d (L_0 g)} \qquad (3)$$

Since the ratio of (2) to (3) is the distribution coefficient k, we obtain the following differential equation:

$$\frac{km}{L_0 (1 - g)} = \frac{-dm}{d (L_0 g)} \qquad (4)$$

Solving this equation,

$$m = m_0 (1 - g)^k \qquad (5)$$

wherein $m_0$ is the initial amount of the impurity, and m is the weight of the impurity present in the melt. In order to obtain the concentration of the impurity, we divide m by $L_0 (1 - g)$, or the weight of the melt, and get:

$$\frac{m_0}{L_0} (1 - g)^{k-1} \qquad (6)$$

If (6) is multiplied by k, we obtain the concentration of the impurity in the solid portion in contact with the melt. Therefore, the impurity concentration C of the solid phase is given by:

$$C = kC_0 (1 - g)^{k-1} \qquad (7)$$

wherein

$$C_0 = \frac{m_0}{L_0} \qquad (8)$$

Formula (7) is equivalent to Willardson's formula (1).

In Fig. 1, the impurity concentration C of the solid phase is plotted on the logarithmic scale as a function of the solidified fraction g. If k is smaller than 1, we obtain curves sloping upwardly and if k is greater than 1, we obtain downwardly sloping curves.

As formula (8) shows, $C_0$ is the initial impurity concentration. The amount of drop in the freezing point is proportional to the impurity concentration, and if the concentrations of two impurities are the same, they will cause the same amount of drop in the freezing point. Of the two impurities that have the same lowering effect of freezing point, the one that will not enter the solid phase is better. This means that impurities having distribution coefficients (k) of appreciably smaller than one should be used. Therefore, Willardson postulated that impurities capable of producing III-V single crystals with minimum lattice defects should satisfy following conditions:

(1) they have distribution coefficients (k) of 0.02 or less; and

(2) they cause a drop in the freezing point by at least 100°C.

According to Table 1 given in Willardson's patent, the impurities the relation k < 0.02 in the AlSb crystal are B, Co, Cu, Pb, Mn and Ni. In the GaSb crystal, Cd is the only impurity that satisfies the relation k < 0.02. IN the InAs crystal, no impurity has a distribution coefficient of less than 0.02. The impurities that satisfy K < 0.02 in the InSb crystal are Cu, Ge, Au and Ni. According to Willardson, the impurities having distribution coefficients (k) smaller than 0.02 in the GaAs crystal are Sb, Bi, Cd, Ca, Cr, Co, Cu, Fe, Pb and Ni.

However, Willardson also states that the distribution coefficient is not the only parameter that should guide the choice of an impurity; other factors must be considered such as the diffusion coefficient of the impurity, because an impurity having a large diffusion coefficient moves around in the crystal, and makes its electrical properties instable. For example, copper has a distribution coefficient of less than 0.002 (a tenth of the critical level) in GaAs, and the rapid diffusion of copper will make it unsuitable for use in preparing a stoichiometric GaAs crystal. In the presence of copper, the GaAs crystal loses its electrical insulating property and becomes conductive.

According to Willardson, Sb, Bi, In and Pb are the elements that are advantageously added to the GaAs crystal for lowering its freezing point and reducing crystal defects. Whichever element is used as the impurity, at least $1 \times 10^{18}$ atoms must be added per $cm^3$ of the compound. The above mentioned four elements have the following distribution coefficients in GaAs: Sb = 0.016, Bi = 0.0005, In = 0.1 and Pb = 0.0002.

The crystal pulling method used by Willardson is not the LEC method but a rather unique version of the Czokralski method. In the usual pulling method, either polycrystalline GaAs or elemental Ga and As, and an impurity are placed in a crucible and heated to form a melt. In the method used by Willardson, elementary Ga and an impurity (e.g. Sb) are placed in a crucible, and As is placed in a chamber surrounding the crucible. Arsenic is held at 605°C, and the crucible is heated to a higher temperature. The vapors of As enter the crucible to form a melt of GaAs. The seed crystal is dipped in the melt and pulled up with rotation. The crucible is open at the top and is not closed as in the case of the LEC method. This is in order to strike balance between the As vapor and As in the melt. The temperature in the chamber must be held at 605°C except for the crucible.

The GaAs melt forming in the crucible has acquired the liquid state at below 1238°C because the addition of an impurity such as Sb has lowered the freezing point of GaAs. Willardson says that the freezing point of GaAs is lowered by at least 100°C, so we assume GaAs may have become liquid at about 1100°C.

Willardson's patent shows 18 examples of pulling GaAs single crystals by the modified Czochralski method using Sb, Pb and Bi as impurities. Half of the crystals prepared had electron mobilities in the range of 2000—3000 $cm^2$/volt. sec. Some had values between 3000 and 4000 $cm^2$/volt. sec. All crystals were doped with Te or Se to make n-type semiconductors. Willardson gave no example of using In as an impurity. He measured only the carrier concentrations and electron mobilities of the grown crystals. His patent says nothing about the etch pit densities of these crystals probably because he did not measure this parameter.

D. Doubtful points in the theory of Willardson

The theory of Willardson et al. is very intriguing in that it correlates the distribution coefficient to the freezing point lowering effect of an impurity. However, as mentioned in the last paragraph of the previous section, the experimental values listed in Willardson's patent are only those of electron density and its mobility. Since the electron mobility decreases as the electron density increases, a low mobility does not necessarily mean the poor characteristics of the crystal concerned. Even so, electron mobilities in the range of 2000 to 3000 $cm^2$/volt. sec. are not considered very high.

Willardson does not give experimental data for parameters other than electron density and mobility. His failure to show EPD data would be fatal to the purpose of obtaining a stoichiometrically perfect single crystal. The present inventors do not think that the amount of lattice defects is directly related to the electron mobility. If Willardson believes that addition of an impurity leads to fewer lattice defects, he should have measured EPD.

Another doubtful point in Willardson's theory is his evaluation of the drop in freezing point. Camphor which is known as a substance that is highly effective in freezing point depression has a constant for molar freezing point depression at 40°C. This means when 1000 g of camphor has 1 mol of another substance dissolved therein, the freezing point of the solution is lowered by 40°C. With water, this constant is 1.86°C and with benzene, it is 4.9°C.

Suppose a substance having Avogardro's number $N_0$, density $\rho$ and molecular weight M. The number of molecules in a unit volume of this substance, $n_1$, given by:

$$n_1 = \frac{N_0 \rho}{M} \tag{9}$$

This substance contains an impurity at a density $n_2$ (the number of its molecules in a unit volume). The ratio of the number of the molecules of the matrix to that of the molecules of the impurity is given by $n_1 : n_2$. If the molecules of the matrix weighs 1000 g, the number of moles of the impurity is:

$$m_2 = \frac{1000}{M} \times \frac{n_2}{n_1} \tag{10}$$

Substituting (9) into (10), we get the number of moles of the impurity in 1000 g as follows:

$$m_2 = \frac{1000}{N_0 \rho} \times n_2 \tag{11}$$

According to Willardson, $n_2 \geqq 1 \times 10^{18}$ atoms/cm³, on the condition $N_0 = 6 \times 10^{23}$/mol. If is 5 g.cm⁻³, the lower limit for $m_2$ can be calculated as follows:

$$n_2 \geqq \frac{1}{3000} \text{ mol/Kg} \tag{12}$$

If $10^{-8}$ atoms of the impurity per cm³ cause a drop in the freezing point by 100°C, the molar freezing point depression factor, $\Delta Tf$, of matrix molecule should be as follows:

$$\Delta Tf = 3000 \times 100°\text{C/mol} = 3 \times 10^{5}°\text{C/mol} \tag{13}$$

This value is 10,000 times as great as that for camphor. It is unthinkable that GaAs melt should have such a high molar freezing point depression constant. Stated reversely, the maximum drop in freezing point due to the addition of about $10^{18}$ atoms of an impurity per cm³ would be 0.01°C, but certainly not as great as 100°C.

Willardson's assumption that a drop in freezing point is effective for reducing lattice defects would be based on the idea that a lower freezing point reduces the temperature gradient in both the longitudinal and radial directions of the crystal being pulled, thereby decreasing a possible thermal strain. However, such effect is hardly expected from a drop in the freezing point of about 0.01°C. This is why the present inventors believe that Willardson made a mistake in evaluating the effect of a drop in freezing point.

Willardson's method has one more defect. That is, his method is incapable of controlling the temperature in the crucible. Only the interior of the crucible is held at a high temperature Th, and the other part of the chamber is held at 605°C for maintaining the vapor pressure of arsenic constant. No arsenic is placed in the crucible as a starting material. The temperature in the crucible, Th, is not determined by controlling a heater or other components, but by subtracting a freezing point drop $\Delta Tf$ from the melting point of the compound, Tm:

$$Th = Tm - \Delta Tf \tag{14}$$

Since the impurity concentration varies in the process of pulling, $\Delta Tf$ changes, so does Th.

In short, Th or the temperature of the melt in the crucible is not a controllable parameter. It is therefore impossible to control the temperature gradient of the crystal in the radial direction. Willardson's method does not have a sufficient number of variables that can be controlled to ensure the production of a stoichiometrically perfect single crystal. This would be a fatal defect for the purpose of operating Willardson's method on a commercial scale.

In fact, Willardson does not state that his pulling method succeeded in growing crystals having reduced crystal defects. He shows data on electron mobility but this is not particularly good. On the contrary, the values listed in his data are to small to claim the effectiveness of his method.

Therefore, the present inventors conclude that the invention of Willardson based on the idea of mixing a melt of GaAs with at least $10^{18}$ atoms/cm³ of an impurity having a distribution coefficient of 0.02 or less does not achieve the intended effect, and that furthermore, his theory on the depression of freezing point is not correct.

E. Theory of Mil'vidsky

In Journal of Crystal Growth, *52*, pp. 396—403 (1981), M. G. Mil'vidsky, V. B. Osvensky and . S. Shifrin show numerous experimental daa on the effects of dopants on the formation of dislocation structure in single crystals of semiconductors such as Ge and GaAs, and analyzed the data theoretically on the basis of model concepts.

When a single crystal is grown in a crucible by the pulling method, the temperature of the crystal decreases as it departs from the solid-liquid interface. This temperature drop causes a shear stress. Writing $T_m$ for the melting point of the compound, Mil'vidsky states that a dislocation occurs at a temperature higher than 0.7 Tm. Since the compound is soft in this temperature range, a dislocation will occur even under a very small shear stress. No dislocation will occur at temperatures higher than 0.7 Tm, if shearing force $\tau$ is smaller than $10^{-5} - 10^{-4}$G (G is shear modulus), approximately 10 times lower than the upper yield stress.

Therefore, Mil'vidsky introduces a new concept, the critical stress of dislocation generation $\tau c$. This represents the threshold level of a stress that causes a dislocation. If a given shear stress exceeds this value, dislocation takes place, and no dislocation occurs if the stress applied is below this level.

The critical stress of dislocation generation $\tau c$ is high at low temperatures and low at high temperatures. At $T \geqq 0.7$ Tm, the value of $\tau c$ is extremely small.

The most important thing about Mil'vidsky's theory is that the doping to a crystal with an impurity causes an increase in the critical shear stress $\tau c$. Mil'vidsky explains the mechanism of increased $\tau c$ due to doping as follows. He starts with the concept of "movement of a dislocation". Dislocation can be considered as an entity that moves by itself. After one dislocation has moved, another dislocation is formed. A shear force causes rapid movement of dislocations, or high multiplication of dislocations. However, an impurity blocks the movement of dislocations, hence their multiplication.

According to Mil'vidsky, the force of blocking the movement of a dislocation is proportional to the square of the difference between the volume of the matrix element Vo and the volume of an impurity $V_1$, and is in inverse proportion to the diffusion coefficient D of the impurity atom. Mathematically, the blocking force is proportional to the value of Q which is given by:

$$Q = \frac{V_1 - V_0}{V_0}{}^2/D \tag{15}$$

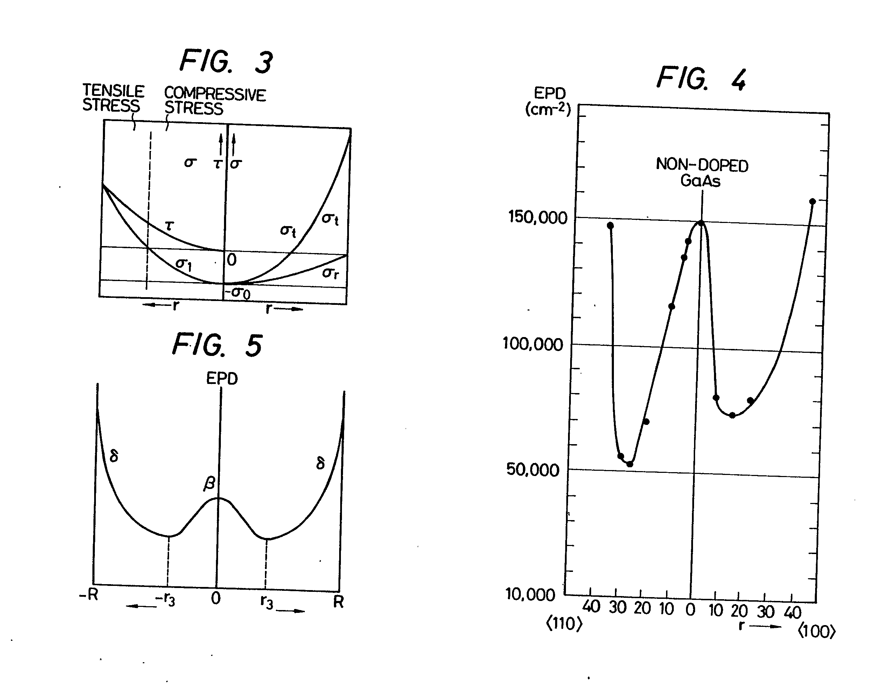

In order to prove this relation, Mil'vidsky gives experimental data that shows the decrease in EPD by increasing the concentrations of dopants (Te, In, Sn and Zn) in GaAs single crystals grown by the LEC method. This data is shown graphically as Fig. 4 in Mil'vidsky's paper and is attached to this specification as Fig. 2, wherein the impurity concentration is plotted on the x-axis and Nd (or EPD in $cm^{-2}$) on the y-axis.

The grown single crystals were 20—25 mm in diameter. With Te doping in concentrations between $5 \times 10^{18}$ and $1 \times 10^{19} cm^{-3}$, Nd was less than $10/cm^2$.

Of the four dopants used, Te is the most effective in diminishing the dislocation density, and next comes In. The following data on In concentration and EPD can be read from the graph of Fig. 2:

(1) In = 0 (undoped), Nd = $1.4 \times 10^4/cm^2$
(2) In = $3.8 \times 10^{18}$ atoms/$cm^3$, Nd = $10^3/cm^2$
(3) In = $1.5 \times 10^{19}/cm^3$, Nd = $1.2 \times 10^2/cm^2$
(4) In = $5.8 \times 10^{19}/cm^3$, Nd = $10^3/cm^2$.

Mil'vidsky gives no data for In concentrations higher than $5.8 \times 10^{19}$ atoms/$cm^3$ (4). The best data for the dislocation density is (3) where Nd = $120/cm^2$ and In = $1.5 \times 10^{19}$ atom/$cm^3$. Between (2) and (3), Nd ranges from 120 to $1000/cm^2$.

If $10^{19}/cm^3$ is used as a unit of measure, the In concentration can be expressed in terms of ni as follows:

$$In = ni \times 10^{19} \text{ atoms/}cm^3 \tag{16}$$

For the range between (2) and (3), Nd indicative of EPD can be approximated by:

$$logNd = 2.669 (log \, ni - 0.176)^2 + 2.077 \tag{17}$$

In the absence of data for ni values greater than 5.8, extrapolation with Eq. (17) gives Nd = $1870/cm^{-2}$ for ni = 7. Mil'vidsky also gives data on Sn and Zn in addition to Te and In.

Mil'vidsky gives the values of Q (see Eq. 15) for Te, Sn and Zn in GaAs at 1100°C. They are:
(1) $8 \times 10^{10}$ sec/$cm^2$ for Te;
(2) $2 \times 10^{10}$ sec/$cm^2$ for Sn; and
(3) $1.5 \times 10^7$ sec/$cm^2$.

No exact value of Q is given for In since there are no data in the literature on the rate of diffusion of In in GaAs.

These data on EPD are given by Mil'vidsky only as a function of dopant concentration. However, Nd is not uniform in an ingot, and it varies even in a single wafer. The values of EPD or Nd shown in Fig. 2 are those for arreas of a single-crystal ingot where minimum levels of EPD are predominant. In other words, those values are the best data for the same ingot.

The EPD of 120/cm$^{-2}$ for In = 1.5 × 10$^{19}$ atoms/cm$^{-3}$ is the best value, and the single crystal of In-doped GaAs will most probably include regions where EPD is between 10$^4$ and 10$^5$/cm$^{-2}$.

F. Problems with Mil'vidsky's theory

Mil'vidsky explains the dislocation blocking effect of an impurity in a crystal by the difference between the volume of the matrix element and that of the impurity element. In spite of its uniqueness, this theory has the following problems.

First, as shown by Eq. (15), the effect of the difference between the volumes of the matrix and impurity elements is that of second degree. Suppose adding In or Al to GaAs as an impurity. The radius of a gallium atom is smaller than that of an indium atom and greater than that of an aluminum atom. If either impurity is doped at the Ga site, the volume effect will be the same for each impurity since the effect is of second degree.

We should here assume an effect of the lower first degree:

$$Q_1 \doteq \frac{V - V_0}{V_0} \qquad (18)$$

It would be unreasonable to think that this effect of first degree plays no role in blocking the movement of dislocations. Aluminum and indium as impurities should have different volume effects on the dislocation density of a crystal.

Another problem with the theory of Mil'vidsky concerns the probability of the occurrence of the volume effect. If $N_1$ is written for the concentration of impurity In, the volume effect of first degree that is given by Eq. (18) should take place at a probability proportional to $N_1$. Since the number of the matrix elements is of the order of 10$^{22}$/cm$^3$, the presence of 10$^{19}$ atoms of the impurity per cm$^3$ means an impurity concentration of 10$^{-3}$. Since Q given by Eq. (15) is of second degree, the probability of its occurrence is proportional to the square of $N_1$, which is 10$^{-6}$.

A dislocation in a crystal can be regarded as a line growing in the axial direction. Mil'vidsky postulates that the dislocation stops moving if the line of dislocation collides against an impurity atom. However, it is strange that impurity atoms having a cross section of collision of 10$^{-6}$ can block dislocations of a density of 10$^5$/cm$^2$ and reduce their density to 100—1000/cm$^2$.

As a further problem, Q in Eq. (15) is obtained by dividing the square of volume difference by diffusion coefficient D. This would be a kind of makeshift that has been managed to differentiate the volume effects of two impurity elements which do not make a great difference as far as the square of the volume difference from the matrix element is concerned.

Take as an example tellurium which, according to Mil'vidsky, is the most effective dopant in diminishing the dislocation density in GaAs. The ionic radius of As$^{3-}$ is 2.22 × 10$^{10}$m where Te$^{2-}$ has an ionic radius of 2.21 × 10$^{-10}$m (see Tables of Physical Constants, New. Ed., published by Asakura Shoten, 1978, p. 211). The Tables also show that Ga$^{3+}$ and Sn$^{4+}$ respectively have ionic radii of 0.62 × 10$^{-10}$m and 0.6 g × 10$^{-10}$m. The volume of an As atom little changes even if its site is replaced by Te, so does the volume of a Ga atom replaced by Sn. The square of the difference in volume between As and Te or between Ga and Sn is almost zero. To avoid Q from becoming zero due to this factor, Mil'vidsky may have divided it by diffusion coefficient D. His reasoning would be that if an impurity atom to block the multiplication of dislocations were thermally excited to move around in the crystal, it would be repelled by the energy of dislocations.

However, the mechanism of blocking the multiplication of dislocations will not be understood any better by depending on a phenomenalistic factor such as diffusion coefficient D. Einstein's relation, D = μkT, suggests that D increases with temperature (μ: atom mobility, K: Boltzmann's constant, T: absolute temperature). Dislocations multiply most actively at high temperatures in the range of Tm ~ 0.7 Tm (Tm: melting point). On the other hand, dislocation blocking ability Q is small at high temperatures and great at low temperatures. It is unthinkable that Q of this nature is capable of blocking the active multiplication of dislocations.

As already mentioned, Mil'vidsky introduces the concept of critical shear stress τc and states that this factor varies with temperature and impurity concentration. If the impurity concentration $N_1$ increases, τc increases accordingly. It is understandable that $N_1$ is significant as a parameter for determining Q by Eq. (15), but Mil'vidsky does not explain why an increase in $N_1$ leads to a higher τc. In order to theorize the high dislocation density in the periphery and the center of a wafer, Mil'vidsky postulated that a high shear stress would occur in these two areas. The idea that a shear force causes a dislocation is intuitional and leaves some doubt about its validity. To show this, let us consider it from the viewpoint of the strength of materials.

A single crystal is cylindrical; when it is pulled upward from the melt its peripheral portion is first cooled by heat dissipation. The center of the crystal is still hot. The cooling peripheral portion contracts and a stress develops in the crystal.

EP 0 148 396 B1

Let us use a cylindrical coordinate system having a z-axis in the longitudinal direction and an r-axis in the radial direction. For simplicity, we do not consider the distribution along the z-axis. Since the crystal is symmetrical with respect to the center point, dependency on angle $\theta$ can be safely disregarded. Write $\sigma r$ for the tensile stress in the radial direction and $\sigma t$ for the tensile stress in the tangential direction. Since the two forces must countervail each other in small areas dr and $d\theta$,

$$\frac{d}{dr}(r\,\sigma r) = \sigma t \tag{19}$$

If the displacement of the continuous body at point r is written as v (r), the linear expansion $\varepsilon r$ at this point in the radial direction is given by:

$$\varepsilon r = \frac{dv}{dr} \tag{20}$$

The linear expansion $\varepsilon t$ at this point in the tangential direction is given by:

$$\varepsilon t = \frac{v}{r} \tag{21}$$

Writing m and E for Poisson's ratio and Young's modulus, respectively, and assuming a constant temperature, the tensile stresses $\sigma r'$ and $\sigma t'$ in the radial and tangential directions are respectively given by:

$$\sigma r' = \frac{E}{1 - \dfrac{1}{m^2}} \left( \frac{dv}{dr} + \frac{1}{m}\frac{v}{r} \right) \tag{22}$$

$$\sigma r' = \frac{E}{1 - \dfrac{1}{m^2}} + \frac{1}{m}\left( \frac{1}{m}\frac{dv}{dr} + \frac{v}{r} \right) \tag{23}$$

If a wire having a Young's modulus E and a linear expansion coefficient $\alpha$ and which is fixed at both ends at temperature $t_0$ is cooled to temperature $t$, a thermal stress develops in the wire and this stress is given by:

$$-\alpha E(t-to) \tag{24}$$

If the temperature is a function of r, the total stress $\sigma r$ or $\sigma t$ is given by the sum of (22) or (23) and the thermal stress:

$$\sigma r' = \frac{E}{1 - \dfrac{1}{m^2}} \left( \frac{dv}{dr} + \frac{1}{m}\frac{v}{r} \right) - \alpha E(t-to) \tag{25}$$

$$\sigma t' = \frac{E}{1 - \dfrac{1}{m^2}} \left( \frac{1}{m}\frac{dv}{dr} + \frac{v}{r} \right) - \alpha E(t-to) \tag{26}$$

Substituting (25) and (26) into (19), we get

$$\frac{d^2v}{dr^2} + \frac{1}{r}\frac{dv}{dr} - \frac{v}{r^2} - \alpha\left(1 - \frac{1}{m^2}\right)\frac{dt}{dr} = 0 \tag{27}$$

9

The differential temperature $(t_0-t)$ is zero at the center of the crystal and increases from the center outward. For simplicity, we approximate the differential temperature by a quadratic function as follows:

$$t_0-t=ar^2 \tag{28}$$

Assuming (28), Eq. (27) can be rewritten as:

$$\frac{d^2v}{dr^2} + \frac{1}{r}\frac{dv}{dr} - \frac{v}{r^2} = -qr \tag{29}$$

wherein

$$q=2a\alpha\left(1-\frac{1}{m^2}\right) \tag{30}$$

This differential equation can be solved. If $-qr = 0$, the general solution of Eq. (29) is given by:

$$v=C_1r + \frac{C_2}{r} \tag{31}$$

We now consider $(-qr)$ in the right side of Eq. (29) and obtain a particular solution for it. Since the right side is of first degree, the left side is also of first degree. We may assume the existence of the following particular solution:

$$v=kr^3 \tag{32}$$

Substituting this into Eq. (29),

$$8kr=-qr \tag{33}$$

Therefore

$$k=-\frac{1}{8}q \tag{34}$$

The symbol v represents the displacement of the continuous body. At the center of the ingot, $r=0$ and the displacement should not diverge, so $C_2$ in Eq. (31) is 0.

Therefore, the general solution of Eq. (29) is

$$v=C_1r-\frac{q}{8}r^3 \tag{35}$$

Substituting this into (25) and (26) and considering (28) and (30), we obtain

$$\frac{\sigma r}{E} = \frac{C_2}{1-\frac{1}{m}} + \frac{r^2a\alpha}{4}\left(1-\frac{1}{m}\right) \tag{36}$$

$$\frac{\sigma t}{E} = \frac{C_1}{1-\frac{1}{m}} + \frac{r^2a\alpha}{4}\left(3-\frac{1}{m}\right) \tag{37}$$

Suppose the ingot has a radius R. At $r=R$, the stress in the radial direction $\sigma r$ is 0. Using this boundary condition

$$C_1=-\left(1-\frac{1}{m}\right)^2\frac{a\alpha R^2}{4} \tag{38}$$

10

From Eqs. (36) and (37), we obtain

$$\frac{\sigma r}{E} = -\left(1-\frac{1}{m}\right)\frac{a\alpha}{4}(R^2-r^2) \qquad (39)$$

$$\frac{\sigma t}{E} = -\left(1-\frac{1}{m}\right)\frac{a\alpha}{4}\left(R^2-\frac{3m-1}{m-1}r^2\right) \qquad (40)$$

The stress in the radial direction $\sigma r$ is always negative for $0\leqq r\leqq R$. In other words, $\sigma r$ is compressive stress. It is maximum at the center ($r=0$), and as $r\to R$, $\sigma r$ becomes small.

The stress in the tangential direction $\sigma t$ is compressive at $r=0$, but zero at $r=r_1$, beyond which $\sigma t$ becomes a tensile stress.

the right half of the graph of Fig. 3 shows the profiles of $\sigma t$ and $\sigma r$ as a function of r. In Fig. 1, $r_1=$

$$r_1 = \sqrt{\frac{m-1}{3m-1}}\, R \qquad (41)$$

For simplicity, let us define normalized stress

$\sigma_0$:

$$\sigma o = \frac{Ea\alpha R^2}{4}\left(1-\frac{1}{m}\right) \qquad (41')$$

Then

$$\sigma r = -\sigma 0\left(1-\frac{r^2}{R^2}\right) \qquad (42)$$

$$\sigma t = -\sigma 0\left(1-\frac{(3m-1)r^2}{(m-1)R^3}\right) \qquad (43)$$

The shear force is zero in both radial and tangential directions.

The following discussion assumes a coordinate system forming an angle $\theta$ with the radial direction. Writing $\sigma_1$ and $\sigma_2$ for tensile stresses and $\tau$ for a shear force, Mohr's relation on stress gives:

$$\sigma 1 = \sigma r\ \cos^2\theta + \sigma t\ \sin^2\theta \qquad (44)$$

$$\sigma 2 = \sigma r\ \sin^2\theta + \sigma t\ \cos^2\theta \qquad (45)$$

$$\left[t = \frac{1}{2}(\sigma r - \sigma t)\ \sin^2\theta\right] \qquad (46)$$

From Eq. (46), the direction of the shear force is at $\theta=45°$. This means a maximum shear force develops in a direction that forms 45° with respect to both the radial direction r and tangential direction t. If we consider a coordinate system for $\theta=45°$, the two tensile stresses are the same and

$$\sigma 1 = \sigma 2 = -\sigma 0\left(1-\frac{2m-1}{m-1}\frac{r^2}{R^2}\right) \qquad (47)$$

with maximum shear force being given by:

$$\tau = \frac{m\sigma 01}{m-1}\frac{r^2}{R^2} \qquad (48)$$

The shear force is zero at $r=0$ and increases in proportion to the square of r.

At r=0, both stresses $\sigma_1$ and $\sigma_2$ are $-\sigma_0$ and compressive. These stresses are zero when r is $r_2$:

$$r_2 = \sqrt{\frac{m-1}{2m-1} \cdot R} \qquad (49)$$

At $r>r_2$, these stresses are positive, or tensile, and remain so until r becomes equal to R.

At r=R

$$\sigma1 = \tau = \frac{m\sigma0}{m-1} \qquad (50)$$

This result is quite natural since we are assuming the boundary condition that $\sigma r=0$ when r=R.

The Poisson's ratios of solids are generally in the range 3 to 4. But under the extreme condition where the solid turns liquid, m→2. The crystal remains fluid immediately after it is withdrawn upward, so the value of m may be close to 2. Then, the absolute value of $\sigma_1=\tau$ given by Eq. (50) when r=R is approximately twice as great as the absolute value of $\sigma_1=-\sigma_0$ for r=0.

The stress concerned is great on the periphery of the crystal; it is also great in the center (r=0) but is small in the vicinity of $r_2$ which is intermediate between the center and the periphery.

The profiles of stress $\sigma_1(=\sigma_2)$ and $\tau$ for the coordinate system when $\theta=45°$ are shown in the left half of Fig. 3. If, as Mil'vidsky states, EPD increases with the shear force, EPD should be minimum at r=0 and increase progressively from the center outward. However, this conclusion does not fit the actual EPD profile wherein EPD is high both at the center and in the periphery and low in the intermediate area. Since the shear force increases in proportion to $r^2$, it is unable to explain the W-shaped distribution of EPD in the radial direction.

One may well regard the W-shaped distribution of EPD as reflecting the change in the primary stress $\sigma1$ because the absolute value of $\sigma1$ is maximum in the periphery, is zero when $r=r_2$ and is about half the peak value when r=0.

G. Hypothesis of the present inventors.

The present inventors postulate that the generation of dislocation is related more closely to the primary stess $\sigma_1$ than to the shear force. The effect of the principal stress $\sigma_1$ on the amount of EPD will vary between tensile stress ($\sigma_1>0$) and compressive stress ($\sigma_1<0$). Shear force would also contribute to the generation of disclocations.

Let us introduce the concept of "dislocation induction coefficient". This factor includes tension coefficient δ, compression coefficient β and shear coefficient γ. Dislocation induction coefficient is defined as the number of EPDs induced per unit quantity that is the square of stress. Since compressive stress occurs when $r<r_2$ and tensile stress when $r>r_2$, the EPD hypothesis of the present inventors can be expressed by the following formulas (σ is written for γ1):

(i) when $0\leqq r<r_2$

$$EPD = \beta\sigma^2 + \gamma\tau^2 \qquad (51)$$

(ii) when $r2<r\leqq R$

$$EPD = \delta\sigma^2 + \gamma\tau^2 \qquad (52)$$

The coefficient δ and β in the primary stress are not zero because EPD was a W-shaped distribution across the diameter of a cylindrical ingot. This explanation is quite contrary to Mil'vidsky's opinion.

As shown by Eq. (51) and (52), our hypothesis also takes τ into account. This factor has an effect on the directivity of EPD. If EPD has directivity, this cannot be explained by the principal stress σ1. The directivity of the frequency of EPD generation can reasonably be explained by τ. Our reasoning is as follows. The factor that is the most sensitive to the shear force is the cleavage direction of a crystal. The cleavage directions of a GaAs crystal are <110>, . . . A crystal pulled in a <001> direction has two cleavage directions forming an angle of 90° with that <001> direction, as well as non-cleavage directions <100>, . . . forming an angle of 45° with each cleavage direction. Maximum shear force develops in a direction forming an angle of 45° with the radius in a certain direction. Looking in a non-cleavage direction <100>, the cleavage direction coincides with the direction of shear force. If shear force generates dislocations, more dislocations should be generated in a <100> direction than in a <110> direction.

Data supporting the above conclusions are shown in Fig. 4. They show the EPD distributions in <100> and <110> directions of an etched wafer sliced from an undoped GaAs single crystal that was grown by a JUMBO furnace of Cambridge Instrument Company, Inc. England. The EPD is plotted on the y-axis and

ranges from $5 \sim 16 \times 10^4/cm^2$. The EPD is the highest in the center and on the periphery and assumes values of about $15 \times 10^4/cm^2$. Minimum EPD in the <110> direction is about $5 \times 10^4/cm^2$ and minimum EPD in the <100> direction is about $7 \times 10^4/cm^2$. The profile shown in 4 agrees with our assumption that $\tau$ should be included in Eqs. (51) and (52).

The EPD values in the <100> direction are greater than those in the <110> direction because, as already mentioned, the direction of shear force $\tau$ coincides with the cleavage direction. One may assume that $\gamma$ is greater in the <100> direction than in the <110> direction. Alternatively, one may assume that if EPD is measured in a direction that forms an angle $\theta$ with the cleavage direction, $\gamma$ is expressed by

$$\gamma = \gamma^0(\varepsilon + \sin^2 2\theta) \tag{53}$$

wherein $\gamma^0$ and $\varepsilon$ are constants.

Upon a closer examination of Fig. 4, the values of radius that give minima of EPD differ between the two directions. In the <110> direction, EPD is minimum when r=2.7 cm, and in the <100> direction, minimum EPD occurs at r=1.5 cm. This can also be explained reasonably by Eq. (51) to (53). The <110> direction is the cleavage direction, so the values of $\gamma$ in that direction are relatively small. As a result, the point ($<r_2$) at which the value of EPD that is given by Eq. (51) and (52) is minimum approaches $r_2$. In the <100> direction, $\gamma$ is great and the point that gives minimum EPD departs from $r_2$. This is why the point at which EPD assumes a minimum value in the <100> direction is closer to r=0 than in the <110> direction.

Writing r3 for the point at which minimum EPD occurs, we obtain the following equation from Eq. (51) and (53):

$$r3 = R\left\{ \frac{\beta(2m-1)(m-1)}{(2m-1)^2\beta + m^2\gamma 0(\varepsilon + \sin^2 2\theta)} \right\}1/2 \tag{54}$$

As already mentioned, $r_3 < r_2$.

Supposing r=4 cm, we obtain the following approximation from the data of Fig. 4:

$$\frac{m^2\gamma 0}{(2m-1)\beta} = 2.2 \tag{55}$$

In obtaining this approximation, we neglected $\varepsilon$ because of its small magnitude. If Poisson's ratio is varied as m=2, 3 and 4, $\gamma 0/\beta$ changes as approximately 5, 6 and 7.

The above data only show the results of a tentative calculation made on an undoped GaAs single crystal characterized in Fig. 4. The conclusion drawn from the above analysis is that the asymmetricity of EPD distribution between <100> and <110> directions can be explained by taking the shear coefficient $\gamma$ into account.

Equations (51) and (52) the present inventors postulate as formulas that explain the EPD distribution across a single-crystal GaAs are graphed in Fig. 5. As shown, the distribution is a W-shaped function:

(i) when r=0

$$EPD = \beta\sigma 0^2 \tag{56}$$

(ii) when r=r3

$$EPD = \frac{\beta\gamma m^2}{\beta(2m-1)^2 + \gamma m^2} \sigma 0^2 \tag{57}$$

(iii) when r=R

$$EPD = \left(\frac{m}{m-1}\right)^2 (\delta + \gamma)\sigma 10^2 \tag{58}$$

Mil'vidsky seems to have considered that the presence of an impurity causes a decrease in $\gamma$ because he believes that an impurity added to a crystal increases the value of the critical shear force, thereby increasing the strength of the crystal structure. However, we do not agree with the opinion that an impurity has the effect of enhancing the critical shear force. It is highly doubtful that an impurity present in the crystal in an amount of 1—0.1% is capable of increasing its critical shear force by a significant amount. The present inventors do not think that the presence of an impurity decreases $\gamma$. Rather, the impurity will reduce the value of normalized stress $\sigma_0$.

13

Normalized stress $\sigma_0$ is given by Eq. (41'), but this equation does not show the exact power of radius (R) as the proportionality constant for normalized stress. By differentiating Eq. (28), we obtain 2aR as the temperature gradient in the radial direction of the crystal surface. Multiplying this by thermal conductivity, we obtain heat dissipation from a unit area by radiation and convection. The heat dissipation defined as above should be constant irrespective of the crystal diameter if the furnace construction, heater temperature and the height of the crystal from the melt surface are the same. In other words, the product of temperature gradient coefficient $a$ and radius R is constant. Therfore, normalized stress $\sigma_0$ is proportional to the first power of R. On the other hand, EPD defined by Eq. (51) and (52) is proportional to the square of $\sigma_0$. Therefore, according to the hypothesis of the present inventors, EPD increases in proportion to the square of radius R. Stated in other words, the difficulty in pulling the desired single crystal upward increases in proportion to the square of radius R. The difficulty in growing a crystal with a diameter of 76 mm is about ten times as great as that involved in growing a crystal with a diameter of 2.54 cm.

The present inventors postulate that the effect of an impurity is reflected in thermal expansion coefficient $\alpha$ in Eq. (41'). The temperature of a single crystal being pulled upward decreases from the peripheral portion toward the center. The resulting isotherm is convex upward. A heat flow occurs in a direction perpendicular to the isotherm and is directed from the center bottom toward the top at an angle with respect to the longitudinal axis. At a certain height, the periphery of the crystal is cooled and begins to contract. The contracting area $(r_3<r)$ is subject to tensile stress.

Tensile stress is significantly relaxed by substitution of an element which is larger in size than matrix elements such as Ga and As. Relaxation of tensile stress means an effective decrease in expansion coefficient $\alpha$. Larger impurity elements were already present in the liquid state, so one may wonder why they are capable of relaxing the tensile stress in a solidifed crystal. A liquid substance has only a short-distance order over atoms. The incorporation of an impurity causes a volume increase corresponding to only one atom. The arrangement of atoms in a solid has a long-distance order. If an impurity of a large size replaces Ga or As, not only does a volume increase occur corresponding to the impurity atom but also the lattice distance between neighboring Ga and As is increased because this requires a lower energy. In the process of transition from the liquid to solid state, an impurity of a large size causes a volume increase. As the solid crystal cools down, the lattice distance between matrix elements Ga and As becomes shorter. In a certain temperature range, the two competing forces are balanced and expansion coefficient $\alpha$, hence $\sigma_0$, effectively approaches zero. As a result, more impurity atoms are incorporated in the crystal lattice in an area of a larger radius than in an area having a smaller radius.

As cooling proceeds further, the center of the crystal being pulled is also solidified and contracts in size. The contracting force originates from the tensile force acting in the peripheral portion. A decrease in the tensile force causes a corresponding decrease in the contracting force. Under the contracting force, atoms of the large-size impurity move downward and come toward the central portion of the crystal. The remaining impurity atoms are left in the center. This causes a high EPD in the center of the crystal.

Since expansion coefficient $\alpha$ is very small, the volume increase due to the impurity present in an amount of a few percent or less is sufficient to substantially cancel the contraction of the crystal due to cooling. In order to decrease $\sigma_0$, R may be reduced, but R must be large enough to meet economical and industrial requirements. The only choice will then be by reducing $a$, or the coefficient providing a thermal gradient. As Eq. (41') shows, a decrease in $a$ leads to a smaller $\sigma_0$. One may well state that a decrease in $a$ permits a greater R.

The impurity is effective in bringing expansion coefficient $a$ to its initial value (when GaAs is undoped). Since, according to Eq. (41'), $a$ need not be appreciably small if $a$ is small, the doping level of the impurity can be decreased if the temperature distribution is highly uniform.

As a conclusion, a high degree of uniformity in temperature distribution is the most important for the purpose of obtaining a GaAs single crystal having a nearly perfect lattice structure.

## Summary of the Invention

The primary object of the present invention is to provide an apparatus for preparing a GaAs single crystal which is substantially free of lattice defects.

Another object of the invention is to provide a nearly perfect GaAs single crystal prepared by this apparatus.

## Brief Description of the Drawings

Fig. 1 is a graph given in Willardon's U.S. Patent No. 3,496,118 that shows the relationship between crystal ratio (solidified fraction) g and the impurity concentration C at the lower end of the crystal, with distribution coefficient k taken as a parameter;

Fig. 2 is a graph given in Mil'vidsky's paper that shows the EPD profile of GaAs crystals grown by the LEC method, as a function of impurity (Te, In, Sn or Zn) concentration;

Fig. 3 is a graph showing in the right half the generation of radial stress σr and tangential stress σt, and in the left half the generation of primary stress $(\sigma_1=\sigma_2)$ in a direction forming 45° with the radius and shear stress τ, in a crystal cooled from the periphery as a function of radius (r);

Fig. 4 is a graph showing the EPD profile in <100> and <110> directions of an undoped GaAs single crystal, as a function of radius (r);

Fig. 5 is a graph showing the EPD function of a GaAs single crystal in the radial direction according to the hypothesis of the present inventors;

Fig. 6 is a section of a single crystal pulling apparatus according to the one embodiment of the present invention;

Fig. 7 is a plan view of a second radiation/convection shielding plate used in the apparatus of Fig. 6;

Fig. 8 is a plan view of a first radiation/convection shielding plate used in the apparatus of Fig. 6;

Fig. 9 is a section of an improved first radiation/convecting shielding plate; and

Fig. 10 is a section of an improved second radiation/convecting shielding plate.

## Detailed Description of the Invention

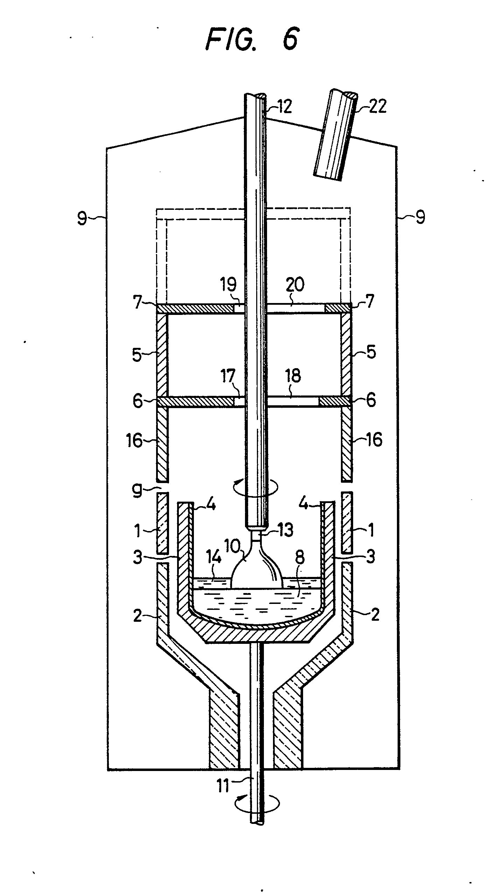

Fig. 6 is a sectional view of the pulling apparatus of the present invention for growing a GaAs single crystal. The apparatus is basically a Czochralski furnace but differs from the conventional type in that it includes two or more heaters and the top of the furnace is covered with a double radiation/convection shielding mechanism. An upper heater indicated at 1 is cylindrical and is primarily used to heat the crystal pulled above the melt surface so as to prevent a rapid drop in the crystal temperature. A lower heater 2 is also cylindrical in the principal part and its primary function is to heat that part of a crucible which is filled with the compound (GaAs) melt. The lower heater 2 is positioned just below the upper heater 1.

Both upper heater 1 and lower heater 2 are shaped from carbon resistance material. A carbon tube is provided with vertical grooves in which current flows alternately in upward and downward directions. By this arrangement, a large current can be applied without producing a net magnetic field within the crucible since the resulting magnetic fields are cancelled by each other.

Both ends of each heater extend downwardly to be connected to electrodes (not shown).

Susceptor 3 and crucible 4 are disposed in a vertically slidable and rotatable manner in the center of the space surrounded by heaters 1 and 2. Susceptor 3 is typically made of carbon and crucible 4 is typically made of pyrolytic boron nitride (PBN). A quartz crucible should not be used because Si escapes into the compound melt to form an n-type semiconductor. The product that is to be prepared by the apparatus of the present invention is a semi-insulating semiconductor with a minimum carrier concentration. In order to prevent the entrance of Si, the use of a quartz crucible should be avoided.

Upper heater 1 is provided on its top with a first radiation/convection shielding tube 16 which is tubular and whose upper portion has a circular cross section. The lower end of the first radiation/convection shielding tube 16 is positioned close to the upper end of the heater 1. The gap $g$ between the lower end of the first shielding tube 16 and the upper end of the heater 1 is made sufficiently small to minimize the occurrence of gaseous convection. A first radiation/convection shielding plate 6 is placed horizontally in a manner that closes the opening in the top of the first shielding tube 16.

Fig 8 is a plan view of the first radiation/convection shielding plate 6. In the embodiment shown, the plate is made of a carbon disk having a diameter of 250 mm. The plate is provided in the center with a hole 17 through which an upper shaft 12 is passed, and an inspection window 18 that is made continuous to said hole 17. In the embodiment shown, hole 17 has a diameter of 120 mm. The edge of the inspection window 18 is spaced from the circumference of the disk by a distance of 25 mm.

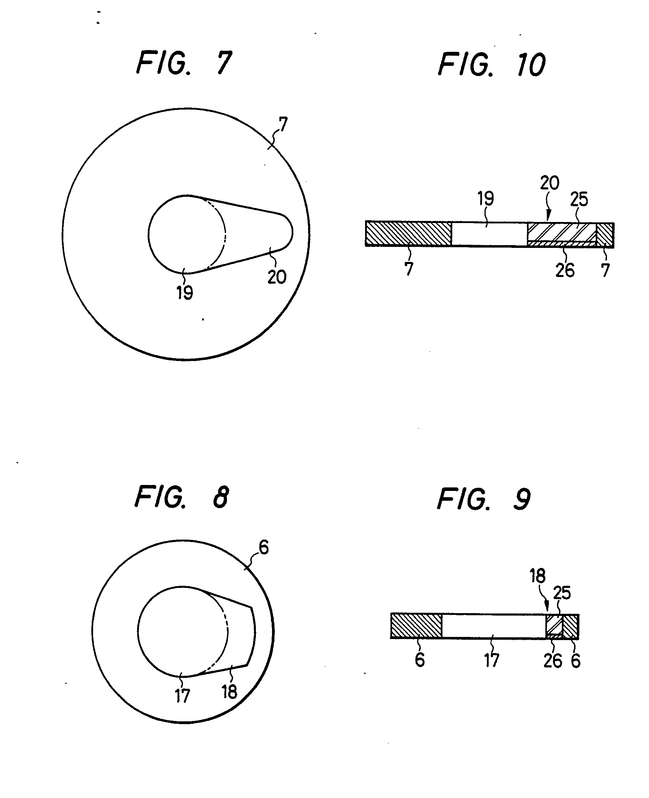

In Fig. 8, the inspection window 18 is shown as a simple opening. For the purpose of preventing convection more effectively, that part of the plate 6 which corresponds to the window 18 may be inlaid with a quartz plate 25 while the hole 17 is left open. A section of the plate 6 according to this modified embodiment is shown in Fig. 9. A better result will be obtained by evaporating a thin Au film 26 on the quartz plate so as to prevent Si leakage from that plate. The operator can observe the growth of a crystal through the translucent Au film 26. Furthermore, heat loss due to radiation can be inhibited by the Au film 26 which reflects almost all of infrared rays that fall on the plate 6.

Above the first radiation/convecting shielding tube 16 is also provided a second cylindrical radiation/convection shielding tube 5. In the embodiment shown in Fig. 6, the tube 5 is made of carbon and has an inside diameter of 280 mm, an outside diameter of 340 mm and a height of 100 mm. The second shielding tube 5 is provided on the top with a disk-shaped secondary radiation/convection shielding plate 7. Again, the center of the second shielding plate 7 is provided with a hole through which the upper shaft 12 is to pass; the second shielding plate 7 is also provided with an inspection window that is continuous to the hole 19. A plan view of the second shielding plate 7 is shown in Fig. 7. In the embodiment shown, the hole 19 has a diameter of 100 mm. Like inspection window 18, window 20 may effectively be closed by a quartz plate 25 with an evaporated Au film 26. A cross section of this modified embodiment is shown in Fig. 10.

The crucible 4 contains a compound melt 8 and a liquid $B_2O_3$ encapsulant 14 that covers said melt. A seed crystal 13 is attached to the lower end of an upper shaft 12 hung from the top of a chamber 9, and as the upper shaft 12 is lifted, a GaAs crystal 10 is pulled upward following the movement of the seed crystal 13.

The underside of the bottom of the susceptor 3 is provided with a supporting lower shaft 11. Each of the upper shaft 12 and the lower shaft 11 is disposed in a vertically slidable and rotatable manner. Each shaft has suitable rotary seals where it passes through the chamber wall.

A high pressure can be maintained within the chamber 9 by supplying a suitable gas such as an inert gas. For example, nitrogen gas may be introduced into the chamber to hold the internal pressure to at least $10^6$ Pa. A quartz rod 22 is inserted into the top of chamber 9 at an angle with respect to the longitudinal axis.

This quartz rod also serves as an inspection window and has typically a diameter of 50 mm. Through inspection windows 22, 20 and 18, the operator can observe the compound melt 8 and the GaAs crystal 10 as it is withdrawn upward from the melt surface. The chamber 9 has an access door or means of opening (not shown) and suitable sealing means to prevent pressure loss.

The apparatus of the present invention differs from the ususal Czochralski pulling apparatus in at least the following two respects: it has upper and lower heaters 1 and 2; the radiation/convection shielding tubes 16 and 5 and radiation/convection shielding plates 6 and 7 provide double shielding from the atmosphere in the space above the heaters so as to ensure minimum occurrence of heat radiation and convection.

The cooling of the single crystal being pulled starts in the vicinity of the melt. With the usual pulling apparatus, lattices defects occur in the single crystal because that part of the crystal which is close to the melt is rapidly cooled. The mechanism by which the single crystal is cooled involves three factors, radiation, convection and conduction. Heat conduction through the upper shaft is negligible. The other factors, convection and radiation, are the primary causes of the cooling of the crystal. In order to prevent convection, the apparatus of the present invention has two sets of radiation/convection shielding plate and tube. The gap between the first shielding tube 16 and the heater 1 is sufficiently small to inhibit convection. Since the crystal is heated to high temperature, heat loss due to radiation would be the most significant factor. Black body radiation is proportional to the fourth power of the absolute temperature.

It is therefore most important to inhibit radiation loss for the purpose of attaining the highest degree of uniformity in heat distribution across the single crystal. It should be considered here that radiation occurs not only on the crystal surface but also on the surface of other components. Suppose a closed space. If the temperature of the boundary between this space and a surrounding space is the same on all points, the total of the heat radiation from and into all points in the space is strictly zero because propagation of radiation energy is proportional to the size of a solid angle.

If the space defined by the radiation/convection shielding plates and tubes is closed and if the temperature of these components are the same as that of the crystal, any radiation loss can be precisely compensated. The first radiation/convection shielding plate 6 has hole 17 and inspection window, 18, whereas the second shielding plage 7 has hole 19 and inspection window 20. In the embodiment shown in Fig. 6, the solid angle subtended by hole 19 and window 20 is smaller than that subtended by hole 17 and window 18, so the radiation loss occurring in the apparatus of the present invention is determined by the second radiation/convection shielding plate 7. The sum of the surface areas of hole 19 and inspection window 20 in the second shielding plate 7 shown in Fig. 6 is about 140 cm². The vertical distance between the solid-liquid interface and the hole 19 and window 20 in the plate 7 is about 30 cm, so the solid angle subtended by 19 and 20 is 0.16 steradians. The solid angle subtended by an opening through which heat radiates is preferably smaller than 0.3 steradians. Three sets of radiation/convection shielding plate and a shielding tube are preferably employed for the purpose of ensuring an even better uniformity in the temperature distribution across the crystal. A third set is indicated in Fig. 6 by the dashed line.

When an opening is made in the radiation/convection shielding plates or inspection if the window is extended to traverse each shielding plate, the growth of a crystal can be easily observed. Therefore, the desired crystal can be pulled upward both by inspection through the window and by checking a weight change as sensed by a weight signal detector attached to the upper shaft.

Observation of crystal growth is impossible if that part of each radiation/convection shielding plate which corresponds to the inspection window is completely closed. In this case, the desired crystal can be grown by monitoring the weight change signal shown above, as well as a seed touch signal which indicates a variation in the current that is caused to flow by application of a voltage between the upper and lower shafts. Complete closure of the inspection window will provide a better heat insulation.

Pulling Method

The apparatus of the present invention may be used to pull a B, Sb or In doped GaAs single crystal by direct synthesis. Direct synthesis is a method using elemental Ga and As, not polycrystalline GaAs as starting materials.

Gallium, arsenic and an impurity B, Sb or In are first placed in the crucible. The number of moles of As should be larger than the number of moles of Ga in combination with In or B because some part of As will be lost by evaporation. To the mixture of Ga, As and the impurity, $B_2O_3$ is added. The respective components are melted at a temperature of 800°C or higher and at a pressure of $5 \times 10^6$Pa or higher. As a result, a solid solution of GaAS containing indium is synthesized.

The melt of GaAs is further heated by heaters 1 and 2 so as to provide a constant temperature gradient in the neighbourhood of the melt surface. The tip of the seed crystal 13 on the lower shaft 12 is dipped in the surface of the melt and pulled upward with rotation. The seed crystal preferably has direction <100>. In order to eliminate any dislocation that may be present in the seed, necking method may be performed, by which the diameter of a GaAs crystal that follows the seed crystal is reduced sufficiently to dispel the dislocations to the outside of the crystal. Subsequently, the diameter of the GaAs crystal is gradually increased to form a shoulder which grows to a predetermined diameter. In the subsequent period of the pulling operation, the diameter of the single-crystal ingot is held constant.

The apparatus of the present invention is capable of growing GaAs single crystals having a diameter of

16

at least 50 mm, sometimes 76 mm. The other conditions for pulling GaAs single crystals with the apparatus of the present invention are listed below:

| | |
|---|---|
| Pressure (inert gas) | $2.10^5 - 4.10^6$Pa |
| Pulling rate | 2 — 15 mm/hr |
| Rotational speed of upper shaft | 0 — 50 rpm |
| Rotational speed of lower shaft | 0 — 50 rpm |
| Temperature gradient in $B_2O_3$ | $\leqq 100°C$/cm |

The upper and lower shafts rotate in the same direction or in the counter direction.

Example

(1) Synthesis conditions

A solid solution of indium-containing GaAs was synthesized from elementary Ga, As and In each having a purity of 99.9999%. The respective elements were charged in the crucible in the following amounts:

| | |
|---|---|
| Ga | 1800g (25.82 mol) |
| As | 2000g (26.69 mol) |
| In | 58.8g (0.51 mol) |

Six hundred grams of $B_2O_3$ serving as a liquid encapsulent was also charged in the crucible. Nitrogen gas was fed into the chamber to a pressure of 60 atoms, and current was passed through the upper and lower heaters to elevate the temperature in the crucible to 800°C.

The number of moles of indium taken together with gallium was smaller than that of arsenic by 0.36 moles.

(2) Pulling conditions

| | |
|---|---|
| Pressure ($N_2$ gas) | $15.10^5$Pa |
| Pulling rate | 7 mm/hr |
| Rotational speed of upper shaft | 5 rpm |
| Rotational speed of lower shaft | 20 rpm |
| Temperature gradient in $B_2O_3$ | 30°C/cm |

Current was passed through both upper and lower heaters, and double shielding composed of two sets of radiation/convection shielding tube and plate was employed. A GaAs crystal was pulled by controling its diameter automatically.

(3) GaAs single crystal pulled

The GaAs single crystal pulled was in a generally cylindrical shape. It was about 180 mm long (as between the top of the shoulder and the bottom) and about 76 mm (3 inches) across. The area of the crystal where transition from the shoulder to the side wall of the cylindrical portion occurred was found to have $4.2 \times 10^{19}$ atoms of indium per $cm^3$. The crystal pulled was single-crystal throughout the all length. A thin wafer was sliced from the single-crystal ingot. The wafer was polished and etched in preparation for EPD counting. Minimum EPD was less than 1000 $cm^{-3}$, and in most areas of the wafer, EPD was between 3000 and 10,000 $cm^{-3}$. The wafer had a specific resistivity in the range of $2 \times 10^7$ to $5 \times 10^7$ ohms-cm. One may well consider the wafer as a semi-insulator.

To summarize, the pulling apparatus of the present invention has the following advantages:

(1) It is capable of producing GaAs single crystals which are large in diameter but have a low EPD;

(2) The apparatus has such a small thermal gradient that GaAs crystals with minimum EPD can be grown even if the doping level of B, Sb or In is smaller than $4.2 \times 10^{19}$ atoms/$cm^3$. Satisfactory results can be obtained even if the In concentration is of the order of about $10^{18}$ or $10^{17}$ atoms/$cm^3$.

## EP 0 148 396 B1

**Claims**

1. An apparatus for producing a single crystal of gallium arsenide comprising a pressure-tight chamber enclosing a susceptor for supporting a crucible; means for supporting the susceptor in a rotatable manner; an upper shaft for suspending a seed crystal above the crucible and pulling a crystal therefrom, said shaft being mounted for movement in a rotatable and vertically slidable manner; a lower heater for heating a compound melt within the crucible; an upper heater for heating the crystal being pulled out of the melt; a first radiation/convection shielding tube positioned above the upper heater; a second radiation/convection shielding tube positioned above the first radiation/convection shielding tube; a first radiation/convection shielding plate positioned to close the opening on the upper side of the first radiation/convection shielding tube and having a hole through which the upper shaft passes, a gap being formed between the upper shaft and the first radiation/convection shielding plate; a second radiation/convection shielding plate positioned to close the opening on the upper side of the second radiation/convection shielding tube and having a hole through which the upper shaft passes, a gap being formed between the upper shaft and the second radiation/convection shielding plate.

2. An apparatus according to claim 1 wherein the loss aperture for heat radiation from the solid-liquid interface between the melt and single crystal being pulled therefrom is determined by only the hole in the first and second radiation/convection shielding plates through which the upper shaft passed and an inspection window in said plates, the solid angle of said loss apertures being smaller than 0.3 steradians.

3. An apparatus according to claim 1 including an inspection window in at least one of the first and second radiation/convection shielding plates, said inspection window decreasing the gap between the plate and the upper shaft.

4. An apparatus according to claim 1 including an inspection window made in the first and second radiation/convection shielding plates, at least one of said windows being closed with a quartz plate, the underside of which has an evaporated gold film.

5. An apparatus according to claim 1 including an inspection window in the first and second radiation/convection shielding plates, which decreases the gap between the upper shaft and the plate.

6. An apparatus according to claim 1 wherein a third radiation/convection shielding plate and a third radiation/convection shielding tube are positioned above the second radiation/convection shielding plates, said third radiation/convection shielding plate being positioned to close the opening on the upper side of said third radiation/convection shielding tube.

7. A gallium arsenide single crystal produced by the following procedure:

synthesizing a solid solution of GaAs at high temperature and pressure from elementary gallium, elementary arsenic, and a liquid encapsulent in a crucible in the presence or absence of elementary boron, anitmony or indoum as an impurity, the number of moles of arsenic being larger than that of gallium;

melting the solid solution of GaAs;

dipping a seed crystal in the free surface of the melt;

pulling the seed crystal out of the melt while the melt is heated by a lower heater and the crystal being withdrawn upwardly is heated by an upper heater, the crystal being withdrawn in such a manner as to minimise the temperature gradient across the crystal by means of at least two sets of a radiation/convection shielding plate and a radiation/convection shielding tube wherein a first radiation/convection shielding tube is positioned above the upper heater; a second radiation/convection shielding tube is positioned above the first radiation/convection shielding tube; a first radiation/convection shielding plate is positioned to close the opening on the upper side of the first radiation/convection shielding tube and has a hole through which the upper shaft passes, a gap being formed between the upper shaft and the first radiation/convection shielding plate; and wherein a second radiation/convection shielding plate is positioned to close the opening on the upper side of the second radiation/convection shielding tube and has a hole through which the upper shaft passes, a gap being formed between the upper shaft and the second radiation/convection shielding plate.

**Patentansprüche**

1. Vorrichtung zur Herstellung von einkristallinem Galliumarsenid, umfassend eine druckdichte Kammer in welcher eine Aufnahme zum Abstützen eines Schmelzgefäßes eingeschlossen ist; eine Einrichtung zum Abstützen der Aufnahme in drehbeweglicher Weise; eine obere Welle zum Suspendieren eines Kristallisationskeimes oberhalb des Schmelzgefäßes und zum Wegziehen eines Kristalls daraus, wobei diese Welle drehbeweglich und vertiklaverschieblich gelagert ist; eine untere Heizeinrichtung zum Erwärmen einer Verbindungsschmelze innerhalb des Schmelzgefäßes; eine obere Heizeinrichtung zum Erwärmen des aus der Schmelze abgezogenen Kristalls; ein erstes Strahlungs-/Konvektions-Abschirmrohr, welches oberhalb der oberen Heizeinrichtung positioniert ist; ein zweites Strahlungs-/Konvektions-Abschirmrohr, welches oberhalb des ersten Strahlungs-/Konvektions-Abschirmrohres positioniert ist; eine erste Strahlungs-/Konvektions-Abschirmplatte, welche so positioniert ist daß die Öffnung auf der oberen Seite des ersten Strahlungs-/Konvektions-Abschirmrohres verschließar ist, und welche eine Öffnung aufweist, durch welche die obere Welle hindurchgeht, wobei ein Spalt ausgebildet ist zwischen der oberen Welle und der ersten Strahlungs-/Konvektions-Abschirmplatte; eine zweite Strahlungs-/Konvektions-

18

Abschirmplatte, welche so positioniert ist, daß die Öffnung auf der oberen Seite des zweiten Strahlungs-/·Konvektions-Abschirmrohres verschließbar ist, wobei diese zweite Abschimrplatte eine Öffnung aufweist, durch welche de obere Welle hindurchgeht, wobei ein Spalt ausgebildet ist zwischen der oberon Welle und der zweiten Strahlungs-/Konvektions-Abschirmplatte.

2. Vorrichtung nach Anspruch 1, wobei die Verlustöffnung für Wärmestrahlung aus der Fest-Flüssig-Grenzfläche zwischen der Schmelze und dem daraus hinweggezogenen Einkristall bestimmt ist lediglich durch die Öffnung in der ersten und zweiten Strahlungs-/Konvektions-Abschirmplatte, durch welche die obere Welle hindurchgeht, sowie durch ein Inspektionsfenster in diesen Platten, wobei der Festwinkel (sollid angle) dieser Verlustöffnungen kleiner ist als 0,3 Raumwinkeleinheiten (steradians).

3. Vorrichtung nach Anspruch 1, umfassend ein Inspektionsfenster in wenigstens einer der beiden Strahlungs-/Konvektions-Abschirmplatten, wobei dieses Inspektionsfenster den Spalt zwischen der Platte und der oberon Welle verringert.

4. Vorrichtung nach Anspruch 1, umfassend Inspektionsfenster in der ersten und in der zweiten Strahlungs-/Konvektions-Abschirmplatte, wobei wenigstens eines dieser Fenster mittels einer Quarzplatte geschlossen ist, deren Unterseite eine aufgedampfte Goldschicht aufweist.

5. Vorrichtung nach Anspruch 1, umfassend Inspektionsfenster in der ersten und in der zweiten Strahlungs-/Konvektions-Abschirmplatte, welches den Spalt zwischen der oberen Welle und der Platte verringert.

6. Vorrichtung nach Anspruch 1, wobei eine dritte Strahlungs-/Konvektions-Abschirmplatte und ein drittes Strahlungs-/Konvektions-Abschirmrohr oberhald der zweiten Strahlungs-/Konvektions-Abschirmplatten positioniert ist, wobei diese dritte Strahlungs-/Konvektions-Abschirmplatte so positioniert ist, daß sie die Öffnung auf der oberen Seite des dritten Strahlungs-/Konvektions-Abschirmrohres verschießt.

7. Einkristallines Galliumarsenid, hergestellt durch das folgende Verfahren:

Synthetisieren einer festen Lösung von GaAs bei hoher Temperatur und hohem Druck aus elementarem Gallium, elementarem Arsen und einem flüssigen Einhüllmittel in einem Schmelzgefäß in Answesenheit oder Abwesenheit von elementarem Bor, Antimon oder Indium als eine Verunreinigung, wobei die Molzahl des Arsens größer ist als die des Galliums;

Schmelzen der festen GaAs-Lösung;

Eintauchen eines Kristallkeims in die freie Oberfläche der Schmelze;

Herausziehen des Kristallkeimes aus der Schmelze, während die Schmelze von einer unteren Heizeinrichtung erwärmt wird und das nach oben gezogene Kristall von einer oberen Heizeinrichtung gewärmt wird, wobie das Kristall auf solche Weise'hochgezogen wird, daß der Temperaturgradient über das Kristall mit Hilfe von wenigstens zwei Sätzen aus einer Strahlungs-/Konvektions-Abschirmüngsplatte und einem Strahlungs-/Konvektions-Abschirmrohres minimiert wird, wobei ein erstes Strahlungs-/Konvektions-Abschirmrohr oberhalb der oberen Heizeinrichtung positioniert wird; ein zweites Strahlungs-/Konvektions-Abschirmrohr oberhalb des ersten Strahlungs-/Konvektions-Abschirmrohres positioniert wird; eine erste Strahlungs-/Konvektions-Abschirmplatte positioniert wird, um die Öffnung auf der oberen Seite des ersten Strahlungs-/Konvektions-Abschirmrohres zu schließen und diese Platte eine Öffnung aufweist, durch welche die obere Welle hindurchgeht, wobei ein Spalt zwischen der oberen Welle und der ersten Strahlungs-/Konvektions-Abschirmplatte vorgesehen ist; Positionieren einer zweiten Strahlungs-/Konvektions-Abschirmplatte, um die Öffnung auf der oberen Seite des zweiten Strahlungs-/Konvektions-Abschirmrohres zu schließen, wobei diese Abschirmplatte eine Öffnung aufweist, durch welche die obere Welle hindurchgeht und ain Spalt zwischen der oberen Welle und der zweiten Strahlungs-/Konvektions-Abschirmplatte ausgebilder wird.

## Revendications

1 Appareil de préparation d'un monocristal d'arséniure de gallium, comprenant une chambre étanche à la pression entourant un support d'un creuset, un dispositif destiné à supporter le support afin qu'il puisse tourner, une tige supérieure destinée à suspendre un cristal germe audessus de creuset et à en tirer un cristal, la tige étant montée afin qu'elle se déplace en rotation en en translation verticale, un organe inférieur de chauffage d'un composé fondu placé dans le creuset un organe supérieur de chauffage du cristal tiré à partir de la matière fondue, un premier tube de protection contre le rayonnement et la convection, placé au-dessus de l'organe supérieur de chauffage, un second tube de protection contre le rayonnement et la convection, placé au-dessus du premier tube de protection contre le rayonnement et la convection, une première plaque de protection contre le rayonnement et la convection, placée afin qu'elle ferme l'ouverture de la face supérieure du premier tube de protection contre le rayonnement et la convection at avant un trou par lequel passe la tige supérieure, un gaz étant disposé entre la tige supérieure \et la première plaque protection contre le rayonnement et la convection, une seconde plaque de protection contre le rayonnement et la convection, placée afin qu'elle ferme l'ouverture du côté supérieur de scond tube de protection contre le rayonnement at la convection et ayant un trou par lequel passe la tige supérieure, un espace étant formé entre la tige supérieure et la seconde plaque de protection contre le rayonnement et la convection.

2. Appareil selon la revendication 1, dans lequel l'ouverture de perte d'un rayonnement thermique à partir de l'interface solide-liquide entre la matière fondue et le monocristal tiré est déterminée par le seul trou formé dans la première et dans la seconde plaque de protection contre le rayonnement et la convection, par lequel passe la tige supérieure, et par une fenêtre d'inspection formée dans les plaques, l'angle solide des ouverture de perte étant inférieur à 0,3 stéradian.

3. Appareil selon la revendication 1, comprenant une fenêtre d'inspection formée dans l'une au moins des première et seconde plaques de protection contre le rayonnement et la convection, la fenêtre d'inspection réduisant l'espace compris entre la plaque et la tige supérieure.

4. Appareil selon la revendication 1, comprenant une fenêtre d'inspection formée dans la première et la seconde plaque de protection contre le rayonnement et la convection, l'une au moins des fenêtres formée par une plaque de quartz, la face inférieure de la fenêtre ayant un film d'or formé par évaporation.

5. Appareil selon la revendication 1, comprenant une fenêtre d'inspection formée dans la première et dans la seconde plaque de protection contre le rayonnement et la convection et qui réduit l'espace compris entre la tige supérieure et la plaque.

6. Appareil selon la revendication 1, dans lequel une troisième plaque de protection contre le rayonnement et la convection et un troisième tube de protection contre le rayonnement et la convection sont placés au-dessus de la seconde plaque de protection contre le rayonnement et la convection, la troisième plaque de protection contre le rayonnement et la convection étant disposée afin qu'elle ferme l'ouverture de côté supérieur du troisième tube de protection contre le rayonnement et la convection.

7. Monocristal d'arséniure de gallium préparé par le procéde suivant:
la synthèse d'une solution solide de GaAs à température et pression élevée à partir de gallium élémentaire, d'arsenic élémentaire et d'un liquide d'enrobage, placés dans un creuset, en présence ou en l'absence de bore élémentaire, d'antimoine élémentaire ou d'indium élémentaire constituant une impureté, le nombre de moles d'arsenic étant supérieur à celui de gallium,
la fusion de la solution solide de GaAs,
le trempage d'un cristal germe à la surface libre de la matière fondue.
le tirage du cristal germe à partir de la matière fondue lorsque celle-ci est chauffée par un organe inférieur de chauffage alors que le cristal tiré vers le haut est chauffé par un organe supérieur de chauffage, le cristal étant tiré de manière que le gradient de température dans le cristal soit réduit an minimum à l'aide d'au moins deux jeux d'une plaque et d'un tube de protection contre le rayonnement et la convection, un premier tube de protection contre la rayonnement et la convection, étant placé au-dessus de l'organe supérieur de chauffage, un second tube de protection contre le rayonnement et la convection étant placés au-dessus du premier tube de protection, une première plaque de protection contre le rayonnement et la convection étant placée afin qu'elle ferme l'ouverture de la face supérieure du premier tube de protection et ayant un trou par lequel passe la tige supérieure, un espace étant formé entre la tige supérieure et la première plaque de protection contre le rayonnement et la convection, et une seconde plaque de protection contre le rayonnement et la convection est placée afin qu'elle ferme l'ouverture de la face supérieure de second tube de protection contre le rayonnement et la convection et a un trou par lequel passe la tige supérieure, un espace étant formé entre la tige supérieure at la seconde plaque de protection contre la rayonnement et la convection.

FIG. 1

$$c=kc_0(1-g)^{k-1}$$
$$c_0=1$$

FRACTION SOLIDIFIED g

IMPURITY CONCENTRATION

k=5
k=3
k=2
k=1
0.9
0.5
0.2
0.1
k=0.01

FIG. 2

EPD ($cm^{-2}$)

$Z_n$

$S_n$

$I_n$

$T_e$

3.8

1.67

5.81

(atom/$cm^3$)

EP 0 148 396 B1

EP 0 148 396 B1

*FIG. 3*

TENSILE STRESS  COMPRESSIVE STRESS

$\sigma$  $\tau$  $\sigma$

$\tau$

$\sigma_t$  $\sigma_t$

$\sigma_1$  0

$\sigma_r$

$-\sigma_0$

← r    r →

*FIG. 5*

EPD

$\delta$  $\beta$  $\delta$

-R    $-r_3$    0    $r_3$    R

*FIG. 4*

EPD (cm$^{-2}$)

NON-DOPED GaAs

150,000

100,000

50,000

10,000

40 30 20 10 0 10 20 30 40

⟨110⟩    r →    ⟨100⟩

## FIG. 6

EP 0 148 396 B1

FIG. 7

FIG. 10

FIG. 8

FIG. 9

4